# EUROPEAN PATENT APPLICATION

(11) **EP 4 576 972 A1**
(43) Date of publication of application: **25.06.2025**
(21) Application number: 23218545.4
(22) Date of filing: 20.12.2023
(51) Int. Cl.: H10B 12/00, H01L 25/065, H01L 27/06, H10B 80/00

(54) **A 3D DRAM WITH CMOS-BETWEEN-ARRAY ARCHITECTURE**

(71) Applicant: IMEC VZW, 3001 Leuven (BE); Katholieke Universiteit Leuven, 3000 Leuven (BE)
(72) Inventor: Oh, Hyungrock, 1200 Brussels (BE); Gupta, Mohit, 3001 Heverlee (BE); Wang, Bowen, 3001 Leuven (BE)
(74) Representative: Roth, Sebastian

(57) **Abstract**

The present disclosure relates to a 3D dynamic random access memory (DRAM). The 3D DRAM of this disclosure comprises a CMOS-between-array (CbA) architecture. The DRAM comprises a first memory array, a second memory array, and a CMOS layer comprising circuitry for operating the first memory array and the second memory array, respectively. The CMOS layer is arranged between the first memory array and the second memory array along a first axis. The circuitry of the CMOS layer comprises one or more word line drivers configured to drive word lines associated with respectively the first memory array and the second memory array, and comprises one or more sense amplifiers configured to sense charge on bit lines respectively associated with the first memory array and the second memory array.

## Description

### TECHNICAL FIELD

The present disclosure relates to a dynamic random access memory (DRAM). In particular, this disclosure proposes a three-dimensional (3D) DRAM, that is, a DRAM with a 3D array of memory cells. The 3D DRAM of this disclosure comprises a CMOS-between-array (CbA) architecture.

### BACKGROUND

Currently, there are difficulties in making DRAM smaller, while increasing its storage capacity. In particular, DRAM scaling is facing challenges in terms of reducing the memory cell area, increasing the memory cell density, and achieving higher aspect ratios in the vertical direction of the memory cell. There have been various approaches for creating 3D DRAM to address these difficulties.

The memory array of a DRAM, which includes the memory cells, is connected to a CMOS layer or device. The CMOS layer comprises circuitry to access and operate the memory array. For instance, the circuitry of the CMOS layer comprises word line drivers for driving word lines in the memory array, and comprises sense amplifiers for sensing charge on bit lines of the memory array. The CMOS layer circuitry may comprise additional peripheral circuitry.

A conventional 3D DRAM typically adopts either a CMOS-under-array (CuA) architecture or a CMOS-over-array (CoA) architecture, wherein in both cases the CMOS layer is positioned adjacent to the memory array. These architectures lead to several issues. Firstly, the stacking of the memory array and CMOS layer increases the parasitic loading, since more parasitic elements are introduced. This necessitates taller vertical metal structures in the DRAM. As a consequence, a process for etching holes to form the vertical metal structures is more complicated.

Secondly, the higher aspect ratio of the stacked memory array and CMOS layer may result in the increase of mechanical stress. Thirdly, particularly when scaling the DRAM, a reduced bit line pitch leads to greater area requirements.

### SUMMARY

In view of the above, an objective of this disclosure is to provide an improved architecture for a 3D DRAM. In particular, objectives are to reduce the parasitic loading, reduce mechanical stress, and reduce area consumption of the 3D DRAM.

These and other objectives are achieved by the solution described in the independent claim. Advantageous implementations are described in the dependent claims.

A first aspect of this disclosure is a dynamic random access memory, DRAM, comprising: a first memory array comprising a 3D arrangement of memory cells; a second memory array comprising a 3D arrangement of memory cells; and a CMOS layer comprising circuitry for operating the first memory array and the second memory array; wherein the CMOS layer is arranged, along a first axis, between the first memory array and the second memory array; wherein the circuitry of the CMOS layer comprises one or more word line drivers configured to drive word lines associated with respectively the first memory array and the second memory array; and wherein the circuitry of the CMOS layer comprises one or more sense amplifiers configured to sense charge on bit lines respectively associated with the first memory array and the second memory array.

Due to the separation into the first memory array and the second memory array, compared to the memory array of a conventional DRAM, and due to the arrangement of the first and second memory array sandwiching the CMOS layer, an improved 3D DRAM architecture is achieved. In particular, the design enables reducing the parasitic loading (at the same density), reducing a height of a hole etch process, reducing the mechanical stress, and reducing the area consumption (e.g., by relaxing the (global) bit line pitch).

The DRAM with its 3D arrays of memory cells is a 3D DRAM. The 3D DRAM may be block-addressable, which can be beneficial for its performance, endurance, and energy efficiency, and also the storage density may be increased.

The memory cells may be memory cells as used in a conventional DRAM, each memory cell including a storage capacitor and an access transistor. The memory cells may be arranged in rows and columns, and may be each connected to one word line and one bit line. The circuitry of the CMOS layer may comprise additional elements, for instance, peripheral circuits. The CMOS layer may be an integrated CMOS controller, which may be integrated with the memory array. The CMOS layer may comprise circuitry that is also found in a conventional CMOS for driving DRAM.

In an implementation of the DRAM, in the first memory array and the second memory array, respectively, the word lines extend along a second axis, which is perpendicular to the first axis, and the bit lines extend along the first axis.

The DRAM of the first aspect comprises so-called vertical bit lines, as they extend along the first axis, which is considered the vertical axis in this disclosure. The connection of the vertical bit lines to the global bit lines may reduce the area consumption, due to a more relaxed placement and routing of the sense amplifiers. Additionally, a parasitic bit line loading can be reduced in the 3D DRAM of the first aspect.

In an implementation of the DRAM, the CMOS layer protrudes along the second axis from between the first memory array and the second memory array; a first subset of the word lines is associated with the first memory array and is connected via an exposed first surface of the CMOS layer to the one or more word line drivers; and a second subset of the word lines is associated with the second memory array and is connected via an exposed second surface of the CMOS layer to the one or more word line drivers, wherein the second surface is opposite to the first surface.

For example, the word lines may land on the exposed surface of the CMOS layer, and may be connected to the circuitry close to or at the exposed surface. As another example, the word lines may go through the exposed surface and into the CMOS layer, and may within the CMOS layer be connected and/or routed to the circuitry. The circuitry may be buried in the CMOS layer in such a case. The first subset of word lines may meet the top surface of the protruding CMOS layer from the top, and the second subset of word lines may meet the bottom surface of the protruding CMOS layer from below.

In an implementation of the DRAM, each word line extends along the second axis out of its associated memory array, makes a bend, and then continues to extend along the first axis onto the respective exposed surface of the CMOS layer.

"Making a bend" in this disclosure implies not more than a change of direction. It is not intended to limit the shape of the word line or the type of the direction change.

In an implementation of the DRAM, any word line, which extends out of its associated memory array at a larger distance from the CMOS layer along the first axis than another word line associated with the same memory array, meets the respective exposed surface of the CMOS layer at a larger distance from the associated memory array along the second axis than the other word line.

In an implementation of the DRAM, the DRAM further comprises: a plurality of global bit lines; wherein a first subset of the global bit lines is associated with the first memory array and a second subset of the global bit lines is associated with the second memory array; wherein each bit line is connected to one of the global bit lines; and wherein each global bit line is connected to one sense amplifier of the CMOS circuit.

In an implementation of the DRAM, in the first memory array and the second memory array, respectively, the global bit lines extend along the third axis, which is perpendicular to the first axis and the second axis.

In an implementation of the DRAM, the global bit lines in respectively the first subset and the second subset are numbered sequentially; or the global bit lines are numbered interleaved across the first subset and the second subset.

In an implementation of the DRAM, the CMOS layer protrudes along the third axis from between the first memory array and the second memory array; the global bit lines of the first subset are connected via an exposed first surface of the CMOS layer to the one or more sense amplifiers; and the global bit lines of the second subset are connected via an exposed second surface of the CMOS layer to the one or more sense amplifiers, wherein the second surface is opposite to the first surface.

For example, the global bit lines may land on the exposed surface of the CMOS layer, and may be connected to the circuitry close to or at the exposed surface. As another example, the global bit lines may go through the exposed surface and into the CMOS layer, and may within the CMOS layer be connected and/or routed to the circuitry. The circuitry may be buried in the CMOS layer in such a case. The first subset of global bit lines may meet the top surface of the protruding CMOS layer from the top, and the second subset of global bit lines may meet the bottom surface of the protruding CMOS layer from below.

In an implementation of the DRAM, each global bit line extends along the first axis out of its associated memory array, makes a first bend, then continues to extend along the second axis, makes a second bend, and then continues to extend along the first axis onto the respective exposed surface of the CMOS layer.

In an implementation of the DRAM, any global bit line which extends out of its associated memory array at a larger distance from the respective exposed surface of the CMOS layer along the second axis than another global bit line associated with the same memory array, extends farther along the first axis than the other global bit line before making the first bend, extends farther along the second axis than the other global bit line before making the second bend, and meets the respective exposed surface of the CMOS layer at a larger distance from its associated memory array along the second axis than the other global bit line.

In an implementation of the DRAM, the global bit lines of the first subset are connected by first through-vias, which extend through the first memory array along the first axis to the one or more sense amplifiers of the CMOS layer; and the global bit lines of the second subset are connected by second through-vias, which extend through the second memory array along the first axis to the one or more sense amplifiers of the CMOS layer.

In an implementation of the DRAM, a width of each of the first memory array and the second memory array along the second axis is larger than its height along the first axis.

In an implementation of the DRAM, a width of each of the first memory array and the second memory array along the second axis is smaller than its height along the first axis.

In an implementation of the DRAM, the memory cells in each of the first memory array and the second memory array are organized in a plurality of planes, which are stacked along the first axis, and are organized in each plane in a plurality of rows extending along the second axis, and in a plurality of columns extending along the third axis.

A second aspect of this disclosure is a computer-implemented method for designing a DRAM, the method comprising: obtaining a design of an initial DRAM comprising a memory array with a 3D arrangement of memory cells and comprising a complementary metal-oxide-semiconductor, CMOS, layer arranged adjacent to the memory array along a first axis; separating the memory array into a first memory array and a second memory array; arranging the CMOS layer between the first memory array and the second memory array along the first axis; and adapting the circuitry of the CMOS layer for operating the first memory array and the second memory array; wherein the adapted circuitry of the CMOS layer comprises one or more word line drivers configured to drive word lines associated with respectively the first memory array and the second memory array; and wherein the adapted circuitry of the CMOS layer comprises one or more sense amplifiers configured to sense charge on bit lines respectively associated with the first memory array and the second memory array.

The memory array of the initial DRAM, e.g. a conventional DRAM, may be separated along a horizontal axis or a vertical axis of the array, i.e., along the rows of memory cells of the memory array or along the columns of memory cells of the memory array. This may be referred to as a "horizontal cut" (H-CUT) or a "vertical cut" (V-CUT) in this disclosure. In case of a H-CUT, the height of the first memory array plus the height of the second memory array is equal to the height of the memory array of the initial DRAM. As an example, each of the first and second memory array may have half the height of the initial memory array. In case of a V-CUT, the width of the first memory array plus the width of the second memory array is equal to the width of the memory array of the initial DRAM. As an example, each of the first and second memory array may have half the width of the initial memory array.

A third aspect of this disclosure is a computer program comprising instructions which, when the program is executed by a computer, cause the computer to perform the method according to the second aspect.

In summary, this disclosure proposes a 3D DRAM with a CbA architecture. The disclosure further proposes connections between the memory arrays and the circuitry of the CMOS layer. The advantages of this architecture include a minimized (global) bit line parasitic loadings, and a minimized impact of any further stack increase on the area consumption.

### BRIEF DESCRIPTION OF THE DRAWINGS

The above described aspects and implementations are explained in the following description of embodiments with respect to the enclosed drawings:
- FIG. 1: shows a general concept for a DRAM according to this disclosure.
- FIG. 2: shows a perspective view of an example of a DRAM according to this disclosure.
- FIG. 3: shows a top view of the exemplary DRAM of FIG. 2.
- FIG. 4: shows different views of an exemplary DRAM ("H-CUT") according to this disclosure with a "word line staircase" and a "global bit line staircase".
- FIG. 5: shows different views of an exemplary DRAM ("V-CUT") according to this disclosure with a "word line staircase" and a "global bit line staircase".
- FIG. 6: shows different views of another exemplary DRAM ("V-CUT") according to this disclosure with a "word line staircase" and a "global bit line staircase".
- FIG. 7: shows different views of an exemplary DRAM ("H-CUT") according to this disclosure with only a "word line staircase".
- FIG. 8: shows different views of an exemplary DRAM ("V-CUT") according to this disclosure with only a "word line staircase".
- FIG. 9: shows different views of another exemplary DRAM ("V-CUT") according to this disclosure with only a "word line staircase".
- FIG. 10: shows a flow-diagram of a computer-implemented method for designing a DRAM according to this disclosure.

### DETAILED DESCRIPTION OF EMBODIMENTS

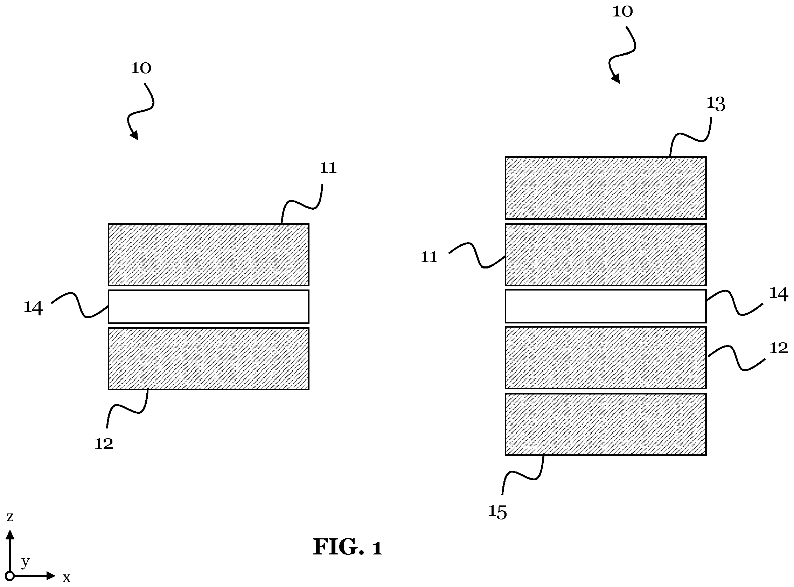

FIG. 1 shows a general concept for designing and manufacturing a DRAM 10 according to this disclosure. The DRAM 10 is a 3D DRAM, as its memory cells are arranged in three dimensions (the three dimensions being defined by three axis, as indicated by the coordinate system in this disclosure).

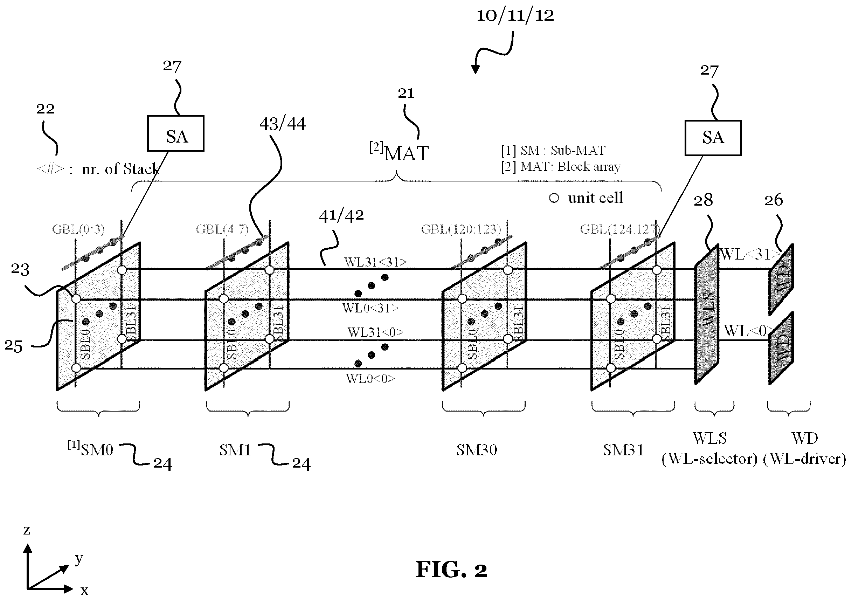

The DRAM 10 comprises at least a first memory array 11 and a second memory array 12, as shown in FIG. 1(a). The first and the second memory array 11, 12 are stacked along a first direction (the vertical axis in this disclosure, which corresponds to the z-axis of the coordinate system). Each memory array 11, 12 comprises a 3D arrangement of memory cells. The memory cells may each comprise a storage capacitor configured to store data in the form of a charge, and a transistor connected to the storage capacitor and configured to enable writing of data to the storage capacitor or reading data from the storage capacitor, i.e., an access transistor. Each memory cell may be able to store one bit of data (information). The memory cells in the 3D DRAM 10 may be arranged in rows, columns, and stacks (as explained with respect to FIG. 2 below).

Further, the DRAM 10 comprises a CMOS layer 14, which is arranged between the first memory array 11 and the second memory array 12 in a direction along the first axis. That is, the first memory array 11, the CMOS layer 14, and the second memory array 12 are stacked along the first axis. The first memory array 11 and the second memory array 12 sandwich the CMOS layer 14 along the first axis.

The CMOS layer 14 comprises circuitry (not shown in FIG. 1) for operating the first memory array 11 and the second memory array 12. In particular, the circuitry of the CMOS layer 14 comprises one or more word line drivers and one or more sense amplifiers. The word line drivers are configured to drive the word lines associated with respectively the first memory array 11 and the second memory array 12, and the sense amplifiers 27 are configured to sense charge on bit lines respectively associated with the first memory array 11 and the second memory array 12. The circuitry of the CMOS layer 14 may further comprise general peripherals, such as an address circuit (ADDR_ckt), a data in/out circuit (DIN(OUT)_ckt), a controller, an address decoder, or a DC generator.

As shown in FIG. 1(b), the DRAM 10 can comprise more than the two memory arrays 11 and 12. As an example, the DRAM could comprise a third memory array 13 and a fourth memory array 15, which may be arranged on opposite sides of the CMOS layer 14. The CMOS layer 14 may be configured to operate these memory arrays 13, 15 as well.

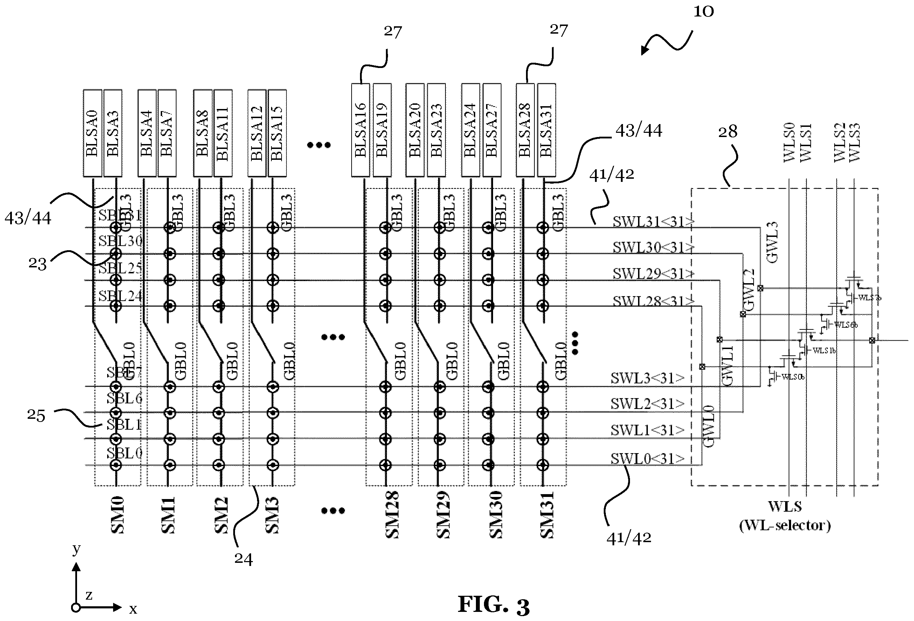

FIG. 2 shows a perspective view of an example of a DRAM 10 according to this disclosure. FIG. 3 shows a corresponding top view of the DRAM 10 of FIG. 2. The DRAM 10 of FIG. 2 and 3 is designed according to the DRAM 10 in FIG. 1. Same elements in FIG. 1, FIG. 2 and FIG. 3 are labelled with the same reference signs.

The DRAM 10 may include one or more blocks 21 including a 3D arrangement of memory cells 23. Each block 21 could correspond to one of the first and the second memory array 11, 12. The DRAM 10 may comprise more than one such block 21, i.e., it may be arranged of multiple blocks 21, which may be individually addressable. In FIG. 2, the block 21 is called a "MAT". The block 21 comprises multiple planes 22, which are stacked along the first axis. As shown in FIG. 3, each plane 22 comprises a 2D array of memory cells 23, which are organized in rows extending along a second axis perpendicular to the first axis (the second axis corresponds to the x-axis in the coordinate system) and columns extending along a third axis perpendicular to the first and the second axis (the third axis corresponds to the y-axis in the coordinate system). The stacked planes 22 accordingly include columns, rows, and stacks of memory cells 23, wherein stacks of memory cells 23 comprise memory cells 23 arranged along the first axis.

As shown in FIG. 2, the block 21 maybe divided into multiple sub-blocks 24, which are arranged along the second axis. Each sub-block 24 may contains one column of memory cells 23 of each plane 22. The consecutive arrangement of the sub-blocks 24 defines the rows of memory cells 23 along the second axis. Each sub-block 14 may be individually addressable in the DRAM 10, and the multiple sub-blocks 14 are respectively called "Sub-MAT" or short "SM". The sub-blocks 24 are numbered SMo to SM31 in FIG. 2. Accordingly, each block 21 may be composed of 32 sub-blocks 24 as in this example.

Moreover, the DRAM 10 also comprises a plurality of bit lines 25. Each bit line 25 may extend along the first axis in one of the sub-blocks 24. The bit lines 25 are thus referred to as vertical bit lines in this disclosure. Each bit line 25 is connected to one memory cell 23 in each plane 22. That is, each bit line 25 is connected to a stack of memory cells 23. Each sub-block 25 may comprise 32 vertical bit lines 25, which are called and numbered SBLo to SBL31 per sub block 14 in the example of FIG. 2.

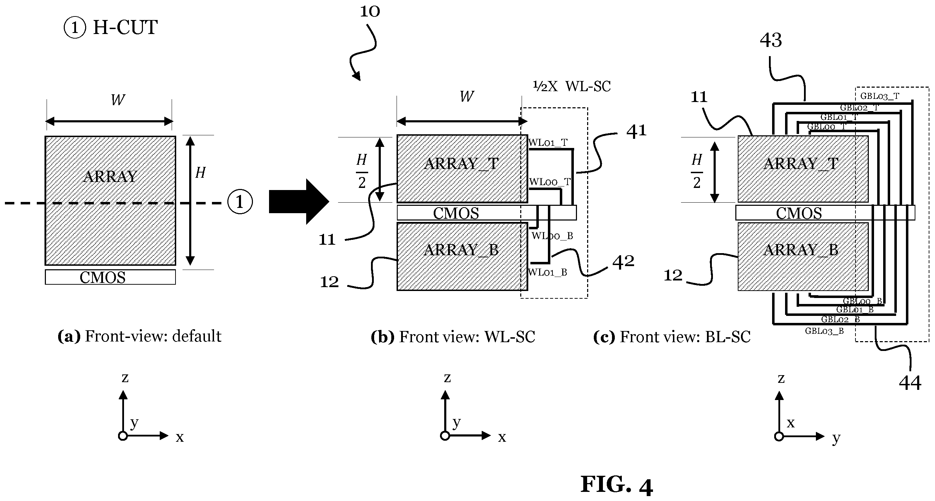

The DRAM 10 of FIG. 2 and 3 includes a plurality of global bit lines 43/44 (explained in more detail with respect to FIG. 4). The global bit lines 43/44 are connected to the bit lines 25 in each sub-block 24. The global bit lines 43/44 are used to improve the connection between the bit lines 25 and the sense amplifiers 27 (which are part of the CMOS layer 14, and are indicated only schematically in FIG. 2), while taking into account a smaller bit line pitch. Each global bit line 43/44 extends along the third axis in the sub-block 24 in this example, and is associated with one respective sub block 24 of the multiple sub-blocks 24. Each global bit line 43/44 is connected to multiple bit lines 25 in said respective sub-block 24. The global bit lines 43/44 are called and numbered GBL0 to GBL127, wherein four of them correspond to each sub-block 24 SMo to SM31 in this example. Each global bit line 43/44 is connected to one sense amplifier 27 (not all SA are shown in FIG. 2).

The DRAM 10 of FIG. 2 and 3 comprises a plurality of word lines 41/42 (explained in more detail with respect to FIG. 4). Each word line 41/42 extends in one of the stacked planes 22 along the second axis. Thereby, each word line 41/42 is connected to one memory cell 23 in each of the multiple sub-blocks 24. If the word line 41/42 is operated (charged), the memory cells 23 connected to the word line 41/42 may be activated. For instance, the transistor connected to the storage capacitor of the memory cell 23 may be turned on, in order to allow charge to be written to or read from the storage capacitor. Reading and writing may be conducted via the bit line 25 connected to this memory cell 23. In total, in this example, there are 32 word lines 41/42 for each of 32 planes. The word lines 21 are called and numbered WLo<o> to WL31<31>, wherein <#> denotes the particular plane with number # of the 32 planes.

FIG. 2 also shows that the 3D DRAM 10 has, in addition to the memory cell array, a plurality of word line drivers 26 (only two "WD" are shown, and they are part of the circuitry of the CMOS layer 14), and a plurality of word line selectors 28 (only two "WLS" are shown, and they may be part of the circuitry of the CMOS layer 14). Each word line driver 26 may be shared among word lines 41/42 of the same plane 22. Thus, there may be 32 word line drivers 26 in this example. However, multiple planes 22 may also share a word line driver 26, which may reduce the number of word line drivers 26 further. The word line selectors 28 are configured to selectively connect the word line drivers 26 to the word lines 41/42. The word lines selectors 28 allow selecting one word line 41/42 out of all the word lines in a plane 22. Since only one word line 41/42 is activated in the block 21 at a time, a word line driver 26 can be shared among multiple word lines 41/42. The DRAM 10 could also comprises only a single word line selector 28 shared among all the word lines 41/42. It is also possible to swap the word line selector(s) 28 and word line driver(s) 26. For instance, one or more word line selectors 28 could be configured to selectively connect an output of an address decoder to a plurality of word line drivers 26, wherein the plurality of word line drivers 26 would be connected to the plurality of word lines 41/42. In this way, the number of word line selectors 28 may be reduced, which may lead to a reduction of the area consumed by word line selectors 28 as well.

FIG. 3 shows only one plane 22 of the plurality of planes 22 of the DRAM 10. FIG. 3 shows how the bit lines 25 are connected, on the one hand, to the memory cells 23 of the 2D array of that plane 22 and, on the other hand, to the global bit lines 43/44. FIG. 3 also shows how the word lines 41/42 are connected, on the one hand, to the memory cells 23 of the 2D array of that plane 12 and, on the other hand, to the word line selector 28.

FIG. 4 shows different views of an exemplary DRAM 10 according to this disclosure having the CbA architecture. In particular FIG. 4(b) shows a front view of the DRAM 10 along the third axis, while FIG. 4(c) shows a front view of the DRAM 10 along the second axis. FIG. 4(a) shows a front view of a default or conventional DRAM with a CoA architecture, based on which the DRAM 10 of this disclosure may be designed. In particular, the DRAM 10 may be designed based on horizontally separating (H-CUT) the memory array of the conventional DRAM, in order to obtain the first memory array 11 (ARRAY_T) and the second memory array 12 (ARRAY_B). The CMOS layer 14 may be arranged between these first and second memory arrays 11, 12, as already explained with respect to FIG. 1. Due to the H-CUT, compared to a height H of the memory array of the conventional DRAM, the memory arrays 11, 12 of the DRAM 10 have a respective height H/2. The width W may be the same as that of the conventional DRAM.

The DRAM 10 of FIG. 4 comprises a "word line staircase", which is shown in FIG. 4(b), and a "global bit line staircase", which is shown in FIG. 4(c). These "staircases" are explained in the following.

For designing the "word line staircase", as shown in FIG. 4(b), the CMOS layer 14 protrudes along the second axis from between the first memory array 11 and the second memory array 12. The word lines 41, 42 comprise a first subset of the word lines 41, which are associated with the first memory array 11, and a second subset of the word lines 42, which are associated with the second memory array 12. The first subset of word lines 41 is connected via or through an exposed first surface of the CMOS layer 14 (e.g., from the top) to the one or more word line drivers 26 (not shown) in the circuitry of the CMOS layer 14. The second subset of the word lines 42 is connected via or through an exposed second (opposite) surface of the CMOS layer 14 (e.g., from below) to the one or more word line drivers 26.

Thereby, each word line 41, 42 of either the first subset or the second subset extends along the second axis out of its associated memory array 11, 12, makes a bend (i.e., changes its extension direction, nothing more is required for "making a bend"), and then continues to extend along the first axis and onto the respective exposed surface of the CMOS layer 14 (respectively, from the top or from below). Each word line 41, 42 of either the first or the second subset, which extends out of its associated first or second memory array 11, 12 at a larger distance from the CMOS layer 14 (measured along the first axis) than another word line 41, 42, which is associated with the same memory array 11, 12, meets the respective exposed surface (first or second exposed surface) of the CMOS layer 14 at a larger distance from the associated memory array 11, 12 (measure along the second axis) than the other word line 41, 42. For instance, the word line WL01_T extends from the first array 11 at a larger distance from the CMOS layer 14 than the word line WLoo_T. Thus, WL01_T meets the CMOS layer 14 at a larger distance from the array 11 than the WLoo_T. The same is true for the word lines WLoo_B and WL01_B extending from the second memory array 12. For the H-CUT, a reduced extension of the "word line staircase" along the second axis may be achieved compared to V-CUT.

For designing the "global bit line staircase", as shown in FIG. 4(c), the CMOS layer 14 also protrudes along the third axis from between the first memory array 11 and the second memory array 12. The global bit lines 43, 44 comprise a first subset of the global bit lines 43, which are associated with the first memory array 11, and a second subset of the global bit lines 44, which are associated with the second memory array 12. The first subset of global bit lines 43 is connected via or through the exposed first surface of the CMOS layer 14 to the one or more sense amplifiers 27. The second subset of global bit lines 44 is connected via or thorough the exposed second surface of the CMOS layer 14 to the one or more sense amplifiers 27 (not shown in FIG. 4).

Thereby, each global bit line 43, 44 extends along the first axis out of its associated first or second memory array 11, 12, then makes a first bend (i.e., changes direction), then continues to extend along the second axis, the makes a second bend (i.e., changes direction again), and then continues to extend along the first axis and onto the respective exposed first or surface of the CMOS layer 14. Each global bit line 43, 44 of either the first or second subset, which extends out of its associated first or second memory array 11, 12 at a larger distance from the respective exposed first or second surface of the CMOS layer 14 (measured along the second axis) than another global bit line 43, 44 associated with the same memory array 11, 12, extends farther along the first axis than the other global bit line 43, 44 before making the first bend, extends farther along the second axis than the other global bit line 43, 44 before making the second bend, and meets the respective exposed first or second surface of the CMOS layer 14 at a larger distance from its associated memory array 11, 12 than the other global bit line 43, 44 (measured along the second axis). For instance, the global bit line GBL03_T extends from the first array 11 at a larger distance from the first surface of the CMOS layer 14 than the global bit line GBL00_T. Thus, GBL03_T meets the CMOS layer 14 at a larger distance from the array 11 than the GBLoo_T. The same is true for the global lines GBLoo_B and GBL03_B extending from the second memory array 12.

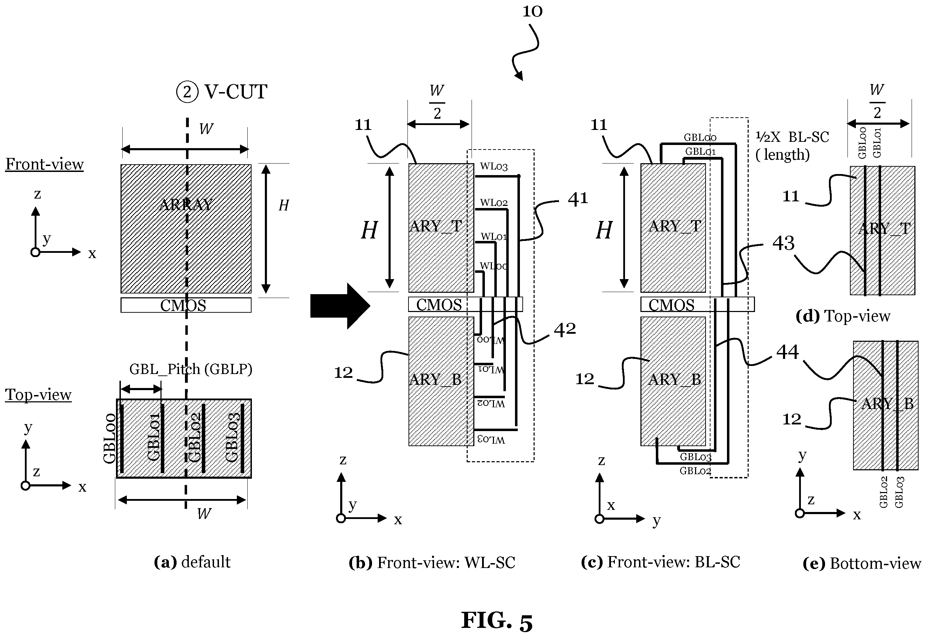

FIG. 5 shows different views of an exemplary DRAM 10 according to this disclosure having the CbA architecture. In particular FIG. 5(b) shows a front view of the DRAM 10 along the third axis, while FIG. 5(c) shows a front view of the DRAM 10 along the second axis. FIG. 5(d) and FIG. 5(e) show a top view and a bottom view of the DRAM 10, respectively (along the first axis). FIG. 5(a) shows a front view and a top view of a default or conventional DRAM with CoA architecture, based on which the DRAM 10 of this disclosure may be designed. In particular, the DRAM 10 may be designed based on vertically separating (V-CUT) the memory array of the conventional DRAM, in order to obtain the first memory array 11 (ARY_T) and the second memory array 12 (ARY_B). The CMOS layer 14 may be arranged between these first and second memory arrays 11, 12, as already shown in FIG. 1. Due to the V-CUT, compared to a width W of the conventional DRAM array, the memory arrays 11, 12 of the DRAM 10 have a respective width W/2. The height H of the first and second memory array 11, 12 may respectively be the same as that of the conventional DRAM.

The DRAM 10 of FIG. 5 has a "word line staircase" and a "global bit line staircase". The "word line stair case" is designed similar to what is shown in FIG. 4(b), and the word lines 41, 42 are configured as described above regarding their extension outside of the memory arrays 11, 12. The "global bit line staircase" is designed similar to what is shown in FIG. 4(c), and the global bit lines 43, 44 are configured as described above regarding their extension outside of the memory arrays 11, 12. For the V-CUT, a reduced extension of the "global bit line staircase" along the second axis may be achieved compared to H-CUT.

FIG. 5(e) shows the global bit lines 43, 44 within the memory arrays 11, 12. As shown, in the first memory array 11 and in the second memory array 12, respectively, the global bit lines 43, 44 extend along the third axis. The first subset of global bit lines 43 extends in the first memory array 11, and the second subset of global bit lines 44 extends in the second memory array 12. In the DRAM 10 of FIG. 5, the global bit lines 43, 44 in respectively the first subset and the second subset are numbered sequentially. For instance, the first subset includes the global bit lines GBL00 and GBL01, while the second subset includes the global bit lines GBL02 and GBL03 (in case of four GBLs 43, 44).

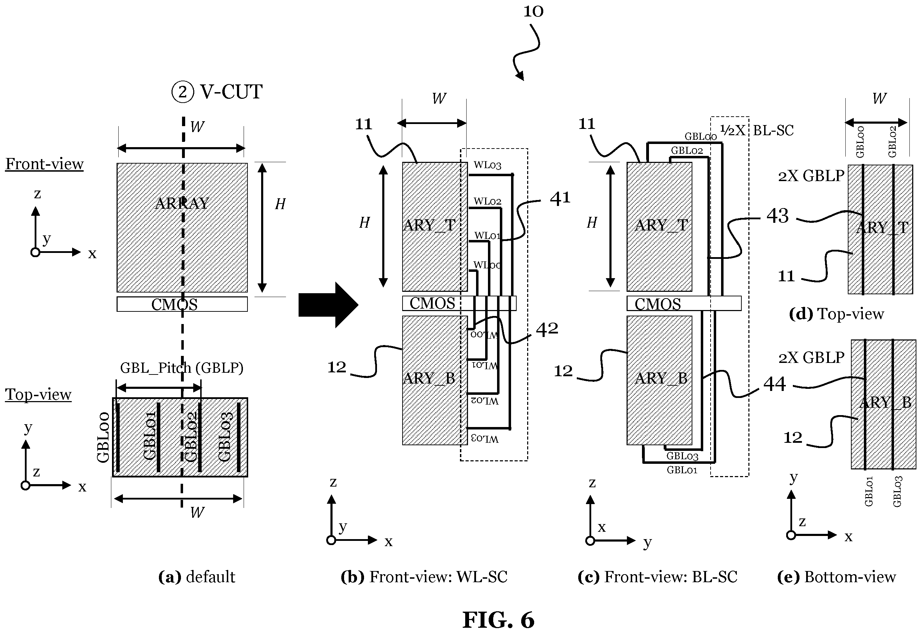

FIG. 6 shows different views of an exemplary DRAM 10 according to this disclosure having the CbA architecture. In particular, FIG. 6(b) shows a front view of the DRAM 10 along the third axis, while FIG. 6(c) shows a front view of the DRAM 10 along the second axis. FIG. 6(d) and FIG. 6(e) show a top view and a bottom view of the DRAM 10, respectively (along the first axis). FIG. 6(a) shows a front view and a top view of a conventional DRAM with the CoA architecture, based on which the DRAM 10 of this disclosure may be designed. In particular, the DRAM 10 may be designed based on vertically separating (V-CUT) the memory array of the conventional DRAM, in order to obtain the first memory array 11 (ARY_T) and the second memory array 12 (ARRAY_B). The CMOS layer 14 may be arranged between these first and second memory arrays 11, 12 as shown in FIG. 1. Due to the V-CUT, compared to a width W of the conventional DRAM array, the memory arrays 11, 12 of the DRAM 10 have a respective width W/2. The height H may be the same as that of the conventional DRAM.

The DRAM 10 of FIG. 6 is similar to the exemplary DRAM 10 shown in FIG. 5. The difference is shown in FIG. 6(d) and FIG. 6(e) compared to FIG. 5(d) and FIG. 5(e). The global bit lines 43, 44 are numbered interleaved across the first subset and the second subset. For instance, the first subset includes the global bit lines GBL00 and GBL02, while the second subset includes the global bit lines GBL01 and GBBL03 (in case of four GBLs 43, 44).

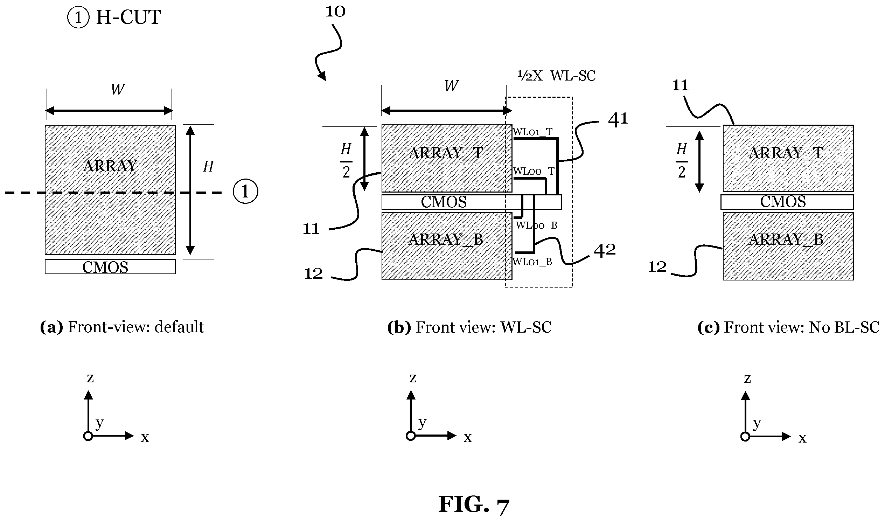

FIG. 7 shows different views of an exemplary DRAM 10 according to this disclosure having the CbA architecture. In particular FIG. 7(b) shows a front view of the DRAM 10 along the third axis, while FIG. 7(c) shows a front view of the DRAM 10 along the second axis. FIG. 7(a) shows a front view of a default or conventional DRAM with CoA architecture, based on which the DRAM 10 of this disclosure may be designed. In particular, the DRAM 10 may be designed based on horizontally separating (H-CUT) the memory array of the conventional DRAM, in order to obtain the first memory array 11 (ARRAY_T) and the second memory array 12 (ARRAY_B). The CMOS layer 14 may be arranged between these first and second memory arrays 11, 12 as already explained with respect to FIG. 1. Due to the H-CUT, compared to a height H of the conventional DRAM array, the memory arrays 11, 12 of the DRAM 10 have a respective height H/2. The width W may be the same as that of the conventional DRAM.

The DRAM 10 comprises only "word line staircase" shown in FIG. 7(b), but no "global bit line staircase" as shown in FIG. 7(c). The "word line stair case" and the word lines 41, 42 are designed and configured as described with respect to FIG. 4(b) outside of the memory arrays 11, 12.

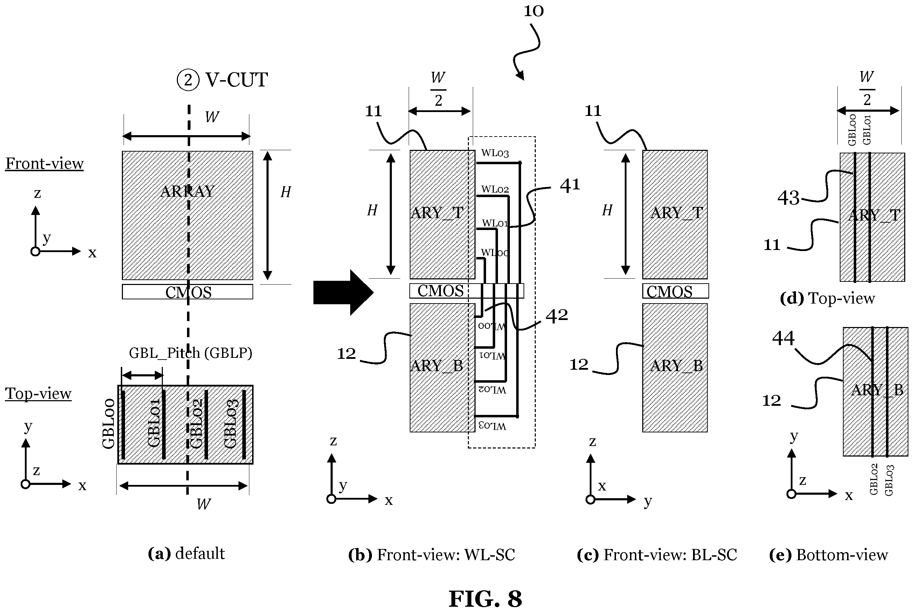

FIG. 8 shows different views of an exemplary DRAM 10 according to this disclosure having the CbA architecture. In particular FIG. 8(b) shows a front view of the DRAM 10 along the third axis, while FIG. 8(c) shows a front view of the DRAM 10 along the second axis. FIG. 8(d) and FIG. 8(e) show a top view and a bottom view of the DRAM 10, respectively (along the first axis). FIG. 8(a) shows a front view and a top view of a conventional DRAM with CoA architecture, based on which the DRAM 10 of this disclosure may be designed. In particular, the DRAM 10 may be designed based on vertically separating (V-CUT) the memory array of the conventional DRAM, in order to obtain the first memory array 11 (ARY_T) and the second memory array 12 (ARY_B). The CMOS layer 14 may be arranged between these first and second memory arrays 11, 12 as shown in FIG. 1. Due to the V-CUT, compared to a width W of the conventional DRAM array, the memory arrays 11, 12 of the DRAM 10 have a respective width W/2. The height H may be the same as that of the conventional DRAM.

The DRAM 10 of FIG. 8 has a "word line staircase" but has no "global bit line staircase", like that in FIG. 7. The "word line stair case" is shown in FIG. 7(b) and the word lines 41, 42 are configured as described with respect to FIG. 4(b) outside of the memory arrays 11, 12. The lack of a "global bit line staircase" is shown in FIG. 7(c), and the global bit lines 43, 44 extend only in the first and second memory array 11, 12, as described with respect to FIG. 5(d) and FIG. 5(e). The global bit lines 43 of the first subset may be connected by first through-vias, which extend through the first memory array 11 along the first axis to the one or more sense amplifiers 27 of the CMOS layer 14. The global bit lines 44 of the second subset may be connected by second through-vias, which extend through the second memory array 12 along the first axis to the one or more sense amplifiers 27 of the CMOS layer 14.

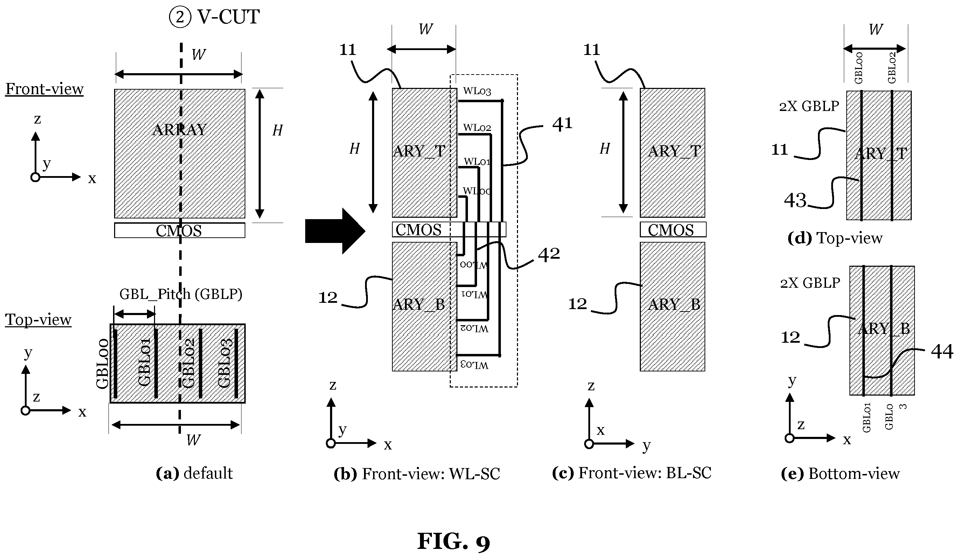

FIG. 9 shows different views of an exemplary DRAM 10 according to this disclosure having the CbA architecture. In particular FIG. 9(b) shows a front view of the DRAM 10 along the third axis, while FIG. 9(c) shows a front view of the DRAM 10 along the second axis. FIG. 9(d) and FIG. 9(e) show a top view and a bottom view of the DRAM 10, respectively (along the first axis). FIG. 9(a) shows a front view and a top view of a conventional DRAM with CoA architecture, based on which the DRAM 10 of this disclosure may be designed. In particular, the DRAM 10 may be designed based on vertically separating (V-CUT) the memory array of the conventional DRAM, in order to obtain the first memory array 11 (ARY_T) and the second memory array 12 (ARY_B). The CMOS layer 14 may be arranged between these first and second memory arrays 11, 12, as shown in FIG. 1. Due to the V-CUT, compared to a width W of the conventional DRAM array, the memory arrays 11, 12 of the DRAM 10 have a respective width W/2. The height H may be the same as that of the conventional DRAM.

The DRAM 10 of FIG. 9 has a "word line staircase" but has no "global bit line staircase", like that in FIG. 8. The "word line stair case" is shown in FIG. 9(b) and the word lines 41, 42 are configured as described with respect to FIG. 4(b) outside of the memory arrays 11, 12. The lack of a "global bit line staircase" is shown in FIG. 9(c), and the global bit lines 43, 44 extend only in the first and second memory array 11, as described with respect to FIG. 6(d) and FIG. 6(e). That is in FIG. 9, the global bit lines 43, 44 are numbered interleaved across the first subset and the second subset, while they are sequential numbered in each subset in FIG. 8.

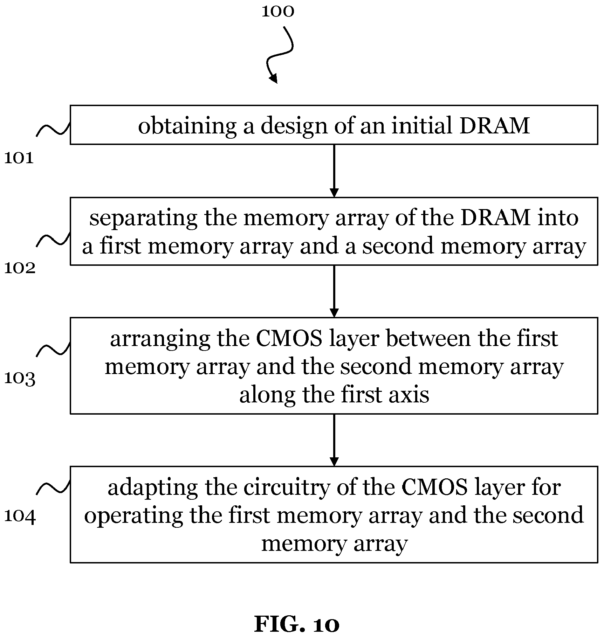

FIG. 10 shows a flow-diagram of a computer-implemented method 100 according to this disclosure. The computer-implemented method 100 can be used for designing a DRAM 10 according to this disclosure, for instance, any one of the DRAMs 10 sown in the previous figures having the CbA architecture.

The method 100 comprises a step 101 of obtaining a design of an initial DRAM comprising a memory array with a 3D arrangement of memory cells 23 and comprising a CMOS layer 14 arranged adjacent to the memory array along a first axis. The design corresponds to a conventional CoA or CuA architecture of a conventional DRAM. The method may obtain an existing design, which may be input into the computer that performs the computer-implemented method 100. The method 100 further comprises a step 102 of separating the memory array of the conventional DRAM into a first memory array 11 and a second memory array 12. The separation may be according to the H-CUT or the V-CUT, as explained before. The method 100 further comprises a step 103 of arranging the CMOS layer 14 between the first memory array 11 and the second memory array 12 along the first axis, as for example shown in FIG. 1. The initial design may have a CMOS layer with a circuitry suitable to operate the memory array of the conventional DRAM. The method 100 comprises a step 104 of adapting the circuitry of the CMOS layer 14 for making it suitable to operate the first memory array 11 and the second memory array 12. In particular, the circuitry is adapted such that the adapted circuitry of the CMOS layer 14 comprises one or more word line drivers 26 configured to drive word lines 41, 42 associated with respectively the first memory array 11 and the second memory array 12, and such that the adapted circuitry of the CMOS layer 14 comprises one or more sense amplifiers 27 configured to sense charge on bit lines 25 respectively associated with the first memory array 11 and the second memory array 12.

The method 100 may be carried out by a computer or a processor. For instance, the method 100 may be carried out based on a computer program. The computer program may comprise instructions which, when the computer program is executed by the computer or processor, cause the computer or processor to perform the method 100.

The computer may comprise processing circuitry configured to perform, conduct or initiate the method 100. The processing circuitry may comprise hardware and/or the processing circuitry may be controlled by software. The hardware may comprise analog circuitry or digital circuitry, or both analog and digital circuitry. The digital circuitry may comprise components such as application-specific integrated circuits (ASICs), field-programmable arrays (FPGAs), digital signal processors (DSPs), or multi-purpose processors. The computer may further comprise memory circuitry, which stores one or more instruction(s) that can be executed by the processor or by the processing circuitry, in particular under control of the software. For instance, the memory circuitry may comprise a non-transitory storage medium storing executable software code which, when executed by the processing circuitry, causes the method 100 to be performed.

In the claims as well as in the description of this disclosure, the word "comprising" does not exclude other elements or steps and the indefinite article "a" or "an" does not exclude a plurality. A single element may fulfill the functions of several entities or items recited in the claims. The mere fact that certain measures are recited in the mutual different dependent claims does not indicate that a combination of these measures cannot be used in an advantageous implementation.

## Claims

1. A dynamic random access memory, DRAM, (10) comprising:
a first memory array (11) comprising a three-dimensional, 3D, arrangement of memory cells (23);
a second memory array (12) comprising a 3D arrangement of memory cells (23); and
a complementary metal-oxide-semiconductor, CMOS, layer (14) comprising circuitry for operating the first memory array (11) and the second memory array (12);
wherein the CMOS layer (14) is arranged, along a first axis, between the first memory array (11) and the second memory array (12);
wherein the circuitry of the CMOS layer (14) comprises one or more word line drivers (26) configured to drive word lines (41, 42) associated with respectively the first memory array (11) and the second memory array (12); and
wherein the circuitry of the CMOS layer (14) comprises one or more sense amplifiers (27) configured to sense charge on bit lines (25) respectively associated with the first memory array (11) and the second memory array (12).

2. The DRAM (10) of claim 1, wherein in the first memory array (11) and the second memory array (12), respectively, the word lines (41, 42) extend along a second axis, which is perpendicular to the first axis, and the bit lines (25) extend along the first axis.

3. The DRAM (10) of claim 1 or 2, wherein:
the CMOS layer (14) protrudes along the second axis from between the first memory array (11) and the second memory array (12);
a first subset of the word lines (41) is associated with the first memory array (11) and is connected via an exposed first surface of the CMOS layer (14) to the one or more word line drivers (26); and
a second subset of the word lines (42) is associated with the second memory array (12) and is connected via an exposed second surface of the CMOS layer (14) to the one or more word line drivers (26), wherein the second surface is opposite to the first surface.

4. The DRAM (10) of claim 3, wherein each word line (41, 42) extends along the second axis out of its associated memory array (11, 12), makes a bend, and then continues to extend along the first axis onto the respective exposed surface of the CMOS layer (14).

5. The DRAM (10) of claim 4, wherein any word line (41, 42), which extends out of its associated memory array (11, 12) at a larger distance from the CMOS layer (14) along the first axis than another word line (41, 42) associated with the same memory array (11, 12), meets the respective exposed surface of the CMOS layer (14) at a larger distance from the associated memory array (11, 12) along the second axis than the other word line (41, 42).

6. The DRAM (10) of one of the claims 1 to 5, further comprising:
a plurality of global bit lines (43, 44);
wherein a first subset of the global bit lines (43) is associated with the first memory array (11) and a second subset of the global bit lines (44) is associated with the second memory array (12);
wherein each bit line (25) is connected to one of the global bit lines (43, 44); and
wherein each global bit line (43, 44) is connected to one sense amplifier (27) of the CMOS layer (14).

7. The DRAM (10) of claim 6, wherein in the first memory array (11) and the second memory array (12), respectively, the global bit lines (43, 44) extend along a third axis, which is perpendicular to the first axis and the second axis.

8. The DRAM (10) of claim 6 or 7, wherein:
the global bit lines (43, 44) in respectively the first subset and the second subset are numbered sequentially; or
the global bit lines (43, 44) are numbered interleaved across the first subset and the second subset.

9. The DRAM (10) of one of the claims 6 to 8, wherein:
the CMOS layer (14) protrudes along the third axis from between the first memory array (11) and the second memory array (12);
the global bit lines (43) of the first subset are connected via an exposed first surface of the CMOS layer (14) to the one or more sense amplifiers (27); and
the global bit lines (44) of the second subset are connected via an exposed second surface of the CMOS layer (14) to the one or more sense amplifiers (27), wherein the second surface is opposite to the first surface.

10. The DRAM (10) of claim 9, wherein each global bit line (43, 44) extends along the first axis out of its associated memory array (11, 12), makes a first bend, then continues to extend along the second axis, makes a second bend, and then continues to extend along the first axis onto the respective exposed surface of the CMOS layer (14).

11. The DRAM (10) of claim 10, wherein any global bit line (43, 44) which extends out of its associated memory array (11, 12) at a larger distance from the respective exposed surface of the CMOS layer (14) along the second axis than another global bit line (43, 44) associated with the same memory array (11, 12), extends farther along the first axis than the other global bit line (43, 44) before making the first bend, extends farther along the second axis than the other global bit line (43, 44) before making the second bend, and meets the respective exposed surface of the CMOS layer (14) at a larger distance from its associated memory array (11, 12) along the second axis than the other global bit line (43, 44).

12. The DRAM (10) of one of the claims 6 to 8, wherein:
the global bit lines (43) of the first subset are connected by first through-vias, which extend through the first memory array (11) along the first axis to the one or more sense amplifiers (27) of the CMOS layer (14); and
the global bit lines (44) of the second subset are connected by second through-vias, which extend through the second memory array (12) along the first axis to the one or more sense amplifiers (27) of the CMOS layer (14).

13. The DRAM (10) of one of the claims 1 to 12, wherein a width of each of the first memory array (11) and the second memory array (12) along the second axis is larger than its height along the first axis.

14. The DRAM (10) of one of the claims 1 to 12, wherein a width of each of the first memory array (11) and the second memory array (12) along the second axis is smaller than its height along the first axis.

15. The DRAM (10) of one of the claims 1 to 14, wherein the memory cells (23) in each of the first memory array (11) and the second memory (12) array are organized in a plurality of planes (22), which are stacked along the first axis, and are organized in each plane (22) in a plurality of rows extending along the second axis, and in a plurality of columns extending along the third axis.

16. A computer-implemented method (100) for designing a dynamic random access memory, DRAM, (10), the method (100) comprising:
obtaining (101) a design of an initial DRAM comprising a memory array with a three-dimensional, 3D, arrangement of memory cells (23) and comprising a complementary metal-oxide-semiconductor, CMOS, layer (14) arranged adjacent to the memory array along a first axis;
separating (102) the memory array into a first memory array (11) and a second memory array (12);
arranging (103) the CMOS layer (14) between the first memory array (11) and the second memory array (12) along the first axis; and
adapting (104) the circuitry of the CMOS layer (14) for operating the first memory array (11) and the second memory array (12);
wherein the adapted circuitry of the CMOS layer (14) comprises one or more word line drivers (26) configured to drive word lines (41, 42) associated with respectively the first memory array (11) and the second memory array (12); and
wherein the adapted circuitry of the CMOS layer (14) comprises one or more sense amplifiers (27) configured to sense charge on bit lines (25) respectively associated with the first memory array (11) and the second memory array (12).
